# EUROPEAN PATENT APPLICATION

(11) **EP 4 707 839 A1**
(43) Date of publication of application: **11.03.2026**
(21) Application number: 25192681.2
(22) Date of filing: 30.07.2025
(51) Int. Cl.: G01R 31/58, G01R 31/60

(54) **CABLE TESTING DEVICE FOR RUNNING LIGHTS WIRE PAIRING AND TRACING AND CABLE TESTER**

(30) Priority: 06.09.2024 CN 202422198610 U
(71) Applicant: Yongzhou Noyafa Electronic Co., Ltd., Yongzhou, Hunan (CN)
(72) Inventor: Lei, Ming, Yongzhou, Hunan (CN); Zhang, Jianping, Yongzhou, Hunan (CN)
(74) Representative: Petraz, Gilberto Luigi

(57) **Abstract**

The present application relates to the technical field of cable testing, disclosing a cable testing device for running lights wire pairing and tracing and a cable tester. By utilizing a main test circuit and a secondary test circuit, the device/tester jointly implements running lights wire pairing and tracing functions for a cable to be test: By implementing, at a first data processing module in the main test circuit, target signal generation and transmission down including a pairing signal and a tracing signal, the first pairing and tracing module cooperates with the first running lights module to respond to the target signal, while the second pairing and tracing module in the secondary test circuit cooperates with the second running lights module to respond to the target signal.

## Description

### TECHNICAL FIELD

The present application relates to the technical field of cable testing, and particularly to a cable testing device for running lights wire pairing and tracing, and a cable tester.

### BACKGROUND

With the continuous development of communication technology, the application of various communication cables in fields such as network communication and data centers has become increasingly widespread. The data transmission and efficiency of communication cables depend on multi-dimensional parameters of the cables. Among these parameters, cable length and wire sequence are the most fundamental. However, in the practical application of cables, accurately measuring these parameters is an unavoidable technical problem. At present, there are many methods for cable length testing, with relatively common ones including direct measurement method, resistance measurement method, capacitance measurement method, time-domain reflectometry (TDR), and time-domain transmission (TDT). However, existing test equipment available on the market that is able to implement cable length measurement has relatively singular measurement functions configured on the device. It often only meets the singular cable testing needs of users, and is not suitable when there is a need to simultaneously measure more multi-dimensional parameters of cables.

### SUMMARY

The present application provides a cable testing device for running lights wire pairing and tracing, which may achieve testing requirements for multi-dimensional parameters of cables, improving the flexibility and convenience of use for cable parameter testing.

To address the aforementioned technical issues, disclosed in a first aspect of the present application is a cable testing device for running lights wire pairing and tracing, wherein the cable testing device includes a main test circuit and a secondary test circuit, the main test circuit including a first pairing and tracing module, a first data processing module connected to the first pairing and tracing module, and a first running lights module; the secondary test circuit including an audio output module, a second pairing and tracing module, a second data processing module connected to the second pairing and tracing module, and a second running lights module, the audio output module being connected to the second data processing module, wherein:
the first data processing module is configured to generate a tracing signal for performing a tracing operation and a pairing signal for performing a pairing operation;
the first pairing and tracing module is configured to transmit the tracing signal and the pairing signal to the second pairing and tracing module via a cable to be test, and is further configured to perform, for the cable to be test, first wire sequence display control on the first running lights module according to the pairing signal;
the second pairing and tracing module is configured to receive the tracing signal and the pairing signal, transmit the tracing signal to the second data processing module, and is further configured to perform, for the cable to be test, second wire sequence display control on the second running lights module according to the pairing signal;
the second data processing module is configured to perform, for the cable to be test, audio output control on the audio output module according to the tracing signal.

As an optional implementation, in a first aspect of the present application, the first pairing and tracing module includes a tracing submodule.

A first port of the first data processing module is electrically connected to a first port of the tracing submodule; a second port of the tracing submodule is in communication connection with a first port of the second pairing and tracing module;
the tracing submodule is configured to generate a transmission signal matching with the tracing signal according to the tracing signal transmitted by the first data processing module; and transmit the transmission signal to the second pairing and tracing module via the cable to be test to trigger the second pairing and tracing module to perform predetermined signal processing on the transmission signal, the predetermined signal processing comprising filter processing and/or signal amplification processing.

As an optional implementation, in a first aspect of the present application, the tracing submodule includes a tracing transmission unit and a tracing transmission port.

A first port of the first data processing module is electrically connected to a first port of the tracing transmission unit; a second port of the tracing transmission unit is electrically connected to a first port of the tracing transmission port;
a second port of the tracing transmission port is in communication connection with a first port of the cable to be test; a second port of the cable to be test is in communication connection with a second port of the second pairing and tracing module;
the tracing transmission unit is configured to perform unit adjustment matching with the tracing signal according to the tracing signal transmitted by the first data processing module, generate a transmission signal matching with the tracing signal, and transmit the transmission signal to the tracing transmission port to transmit the transmission signal to the second pairing and tracing module via the cable to be test through the tracing transmission port.

As an optional implementation, in a first aspect of the present application, the first pairing and tracing module further includes a pairing submodule.

A second port of the first data processing module is electrically connected to a first port of the pairing submodule; a second port of the pairing submodule is electrically connected to a third port of the cable to be test; a third port of the pairing submodule is electrically connected to a first port of the first running lights module;
the pairing submodule is configured to receive the pairing signal transmitted by the first data processing module, perform a pairing operation on the main terminal of the cable to be test according to the pairing signal to obtain a main terminal pairing result for the main terminal of the cable to be test, and transmit the main terminal pairing result to the first running lights module to trigger the first running lights module to perform a first wire sequence display operation according to the main terminal pairing result.

As an optional implementation, in a first aspect of the present application, the second pairing and tracing module includes a tracing reception submodule.

A second port of the tracing transmission port is in communication connection with a first port of the cable to be test; a second port of the cable to be test is in communication connection with a first port of the tracing reception submodule; a second port of the tracing reception submodule is electrically connected to a first port of the second data processing module;
the tracing reception submodule is configured to receive the transmission signal sent by the tracing transmission port, perform predetermined signal processing corresponding to filter processing and/or signal amplification processing on the transmission signal, and transmit a corresponding predetermined signal processing result to the second data processing module;
the second data processing module is configured to determine a signal amplitude corresponding to the predetermined signal processing result, generate an audio output signal matching the signal amplitude, and transmit the audio output signal to the audio output module to output a target audio signal matching the audio output signal through the audio output module;
the second data processing module is further configured to generate a display control signal for the second running lights module according to the predetermined signal processing result, and control the second running lights module to perform a second wire sequence display operation according to the display control signal, the second wire sequence display operation being configured to indicate a signal intensity corresponding to the transmission signal.

As an optional implementation, in a first aspect of the present application, the tracing reception submodule includes a signal processing unit, a filter unit, and a signal amplification unit.

A second port of the tracing transmission port is in communication connection with a first port of the cable to be test; a second port of the cable to be test is in communication connection with a first port of the signal processing unit; a second port of the signal processing unit is electrically connected to a first port of the filter unit and a first port of the signal amplification unit respectively;
a second port of the filter unit is configured to be grounded; a third port of the filter unit is configured to connect to a power supply; a second port of the signal amplification unit is configured to be grounded; a third port of the signal amplification unit is electrically connected to a first port of the second data processing module;
the signal processing unit is configured to receive the transmission signal and transmit the transmission signal to the filter unit;
the filter unit is configured to perform filtering and frequency-selecting operation on the transmission signal and transmit a corresponding filtered frequency-selected signal to the signal amplification unit;
the signal amplification unit is configured to perform a signal amplification operation on the filtered frequency-selected signal and feedback a corresponding signal amplification result to the second data processing module; the signal amplification operation comprises at least two stages of signal amplification processing.

As an optional implementation, in a first aspect of the present application, the second pairing and tracing module further includes a secondary interaction port.

A first port of the secondary interaction port is configured to be electrically connected to a fourth port of the cable to be test; a second port of the secondary interaction port is electrically connected to a first port of the second running lights module;
the pairing submodule is further configured to transmit the pairing signal to the secondary interaction port;
the secondary interaction port is configured to perform the pairing operation on the secondary terminal of the cable to be test according to the pairing signal to obtain a secondary terminal pairing result for the secondary terminal of the cable to be test, and transmit the secondary terminal pairing result to the second running lights module to trigger the second running lights module to perform a second wire sequence display operation according to the secondary terminal pairing result.

As an optional implementation, in a first aspect of the present application, the second pairing and tracing module further includes an interface detection submodule.

A third port of the secondary interaction port is electrically connected to a first port of the interface detection submodule; a second port of the interface detection submodule is electrically connected to a second port of the second data processing module;
the interface detection submodule is configured to collect port operation data corresponding to the secondary interaction port, determine port connection information of the secondary interaction port according to the port operation data, and then transmit the port connection information to the second data processing module; the port connection information comprises first information indicating that the secondary interaction port is connected to the tracing transmission port via a cable or non-first information;
the interface detection submodule is further configured to receive a port control instruction fed back by the second data processing module for the port connection information, and perform port control on the secondary interaction port according to the port control instruction, the port control comprising port start and stop control.

As an optional implementation, in a first aspect of the present application, the main test circuit further includes a cable-length measurement module.

A first port of the cable-length measurement module is configured to be electrically connected to a first port of a cable group to be test; a second port of the cable-length measurement module is electrically connected to a third port of the first data processing module;
the first data processing module is further configured to transmit a generated cable-length measurement trigger signal to the cable-length measurement module while transmitting a preset pulse wave to the cable group to be test;
the cable-length measurement module is configured to perform a measurement operation for the preset pulse wave on the cable group to be test and write a corresponding measurement result into a result register of the cable-length measurement module;
the first data processing module is further configured to read the measurement result, perform calculation based on a preset algorithm on the measurement result, and display a corresponding calculation result on a display module externally connected to the first data processing module.

Disclosed in a second aspect of the present application is a cable tester, the cable tester includes a device body, and the cable tester includes the cable testing device for running lights wire pairing and tracing according to any aforementioned one disclosed in the first aspect.

The implementation of the present application provides the following beneficial effects.

Provided in the present application is a cable testing device for running lights wire pairing and tracing, where the cable testing device includes a main test circuit and a secondary test circuit, the main test circuit including a first pairing and tracing module, a first data processing module connected to the first pairing and tracing module, and a first running lights module; the secondary test circuit including an audio output module, a second pairing and tracing module, a second data processing module connected to the second pairing and tracing module, and a second running lights module, the audio output module being connected to the second data processing module, where: the first data processing module is configured to generate a tracing signal for performing a tracing operation and a pairing signal for performing a pairing operation; the first pairing and tracing module is configured to transmit the tracing signal and the pairing signal to the second pairing and tracing module via a cable to be test, and is further configured to perform, for the cable to be test, first wire sequence display control on the first running lights module according to the pairing signal; the second pairing and tracing module is configured to receive the tracing signal and the pairing signal, transmit the tracing signal to the second data processing module, and is further configured to perform, for the cable to be test, second wire sequence display control on the second running lights module according to the pairing signal; the second data processing module is configured to perform, for the cable to be test, audio output control on the audio output module according to the tracing signal. It is evident that in the present application, the running lights wire pairing and tracing functions for the cable to be test are jointly implemented through the main test circuit and the secondary test circuit: By implementing, at the first data processing module in the main test circuit, the generation and transmission down of the tracing and pairing control instructions (corresponding to the target signal), the first pairing and tracing module in the main test circuit cooperates with the first running lights module to respond to the target signal, while the second pairing and tracing module in the secondary test circuit cooperates with the second running lights module to respond to the target signal. By arranging the running lights modules, the implementation results of the tracing and pairing functions become more prominent, thereby enhancing the convenience of reviewing the tracing and pairing functions. In addition, the main test circuit is configured to implement pairing and tracing of the wire sequence at the main terminal (near end) of the cable, and the secondary test circuit is configured to implement pairing and tracing at the secondary terminal (remote end), thereby integrating the display function of running lights on the basis of achieving the tracing and pairing functions, expanding the application scenarios of this cable testing device, and facilitating improvements in the applicability and practicality of the cable testing device.

### BRIEF DESCRIPTION OF THE DRAWINGS

To describe the technical solutions in the embodiments of the present application more clearly, the following briefly describes the accompanying drawings required for describing the embodiments. Apparently, the accompanying drawings in the following description show merely some embodiments of the present application, and those of ordinary skill in the art may still derive other accompanying drawings from these accompanying drawings without creative efforts.
FIG. 1 is a structural schematic diagram of a cable testing device for running lights wire pairing and tracing according to an embodiment of the present application;
FIG. 2 is a structural schematic diagram of another cable testing device for running lights wire pairing and tracing according to an embodiment of the present application;
FIG. 3 is a structural schematic diagram of a cable tester according to an embodiment of the present application;
FIG. 4 is a structural schematic diagram of a tracing transmission unit according to an embodiment of the present application;
FIG. 5 is a structural schematic diagram of a pairing submodule according to an embodiment of the present application;
FIG. 6 is a structural schematic diagram of a tracing reception submodule according to an embodiment of the present application;
FIG. 7 is a structural schematic diagram of a cable-length measurement module according to an embodiment of the present application.

### DETAILED DESCRIPTION

For a better understanding and implementations, the technical solutions in the examples of the present application are clearly and completely described and discussed below in conjunction with the attached drawings of the embodiments of the present application. Obviously, the examples described herein are only some of the examples of the present application but not all of them. Based on the embodiments in the present application, all other embodiments obtained by those skilled in the art without creative efforts fall within the scope of protection of the present application.

It should be noted that, unless otherwise explicitly specified and limited, the term "electrically connected" in the specification and claims and the drawings mentioned above of the present application should be understood in a broad sense, for example, as a fixed electrical connection, as a detachable electrical connection, or as an integral electrical connection; as a mechanical electrical connection, as an electrical-electrical connection or as an intercommunication; as a direct connection or as an indirect connection through an intermediate medium, as a connection within two elements or as an interaction between two elements. Additionally, the terms "first", "second", and the like in the specification, the claims and the above-mentioned drawings of the present application are used to identify different objects and are not intended to describe a particular sequence. In addition, the terms "comprise" and "include", and any derivatives and conjugations thereof, are intended to cover non-exclusive inclusion. For those skilled in the art, the specific meaning of the above terms in the context of the present application may be understood according to the specific situation.

### Embodiment 1

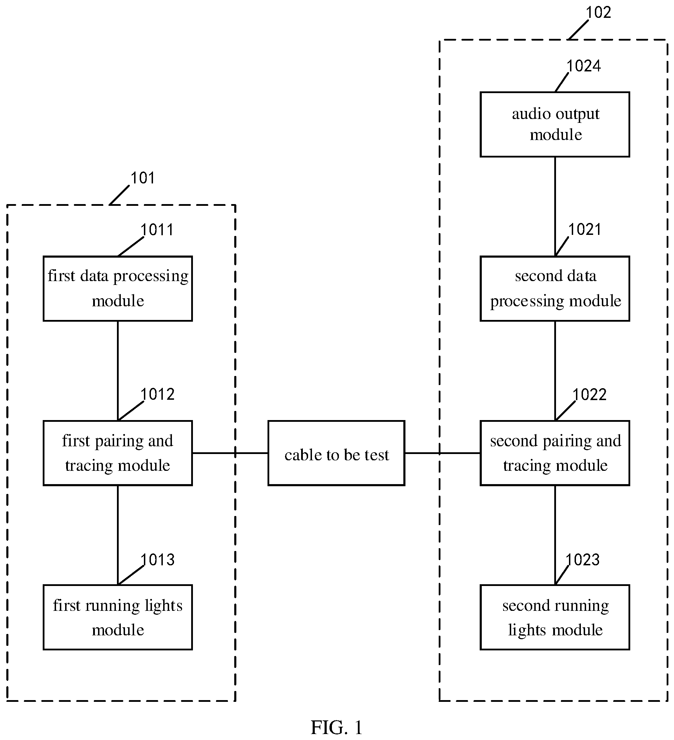

Referring to FIG. 1, FIG. 1 is a structural schematic diagram of a cable testing device for running lights wire pairing and tracing according to an embodiment of the present application. The device may be applied to a cable tester (e.g., a cable tracer, a cable pairing device), which is not limited in the embodiments of the present application. As shown in FIG. 1, the cable testing device for running lights wire pairing and tracing includes a main test circuit 101 and a secondary test circuit 102, the main test circuit 101 including a first pairing and tracing module 1012, a first data processing module 1011 connected to the first pairing and tracing module 1012, and a first running lights module 1013; the secondary test circuit 102 including an audio output module 1024, a second pairing and tracing module 1022, a second data processing module 1021 connected to the second pairing and tracing module 1022, and a second running lights module 1023, the audio output module 1024 being connected to the second data processing module 1021, where:
the first data processing module 1011 is configured to generate a tracing signal for performing a tracing operation and a pairing signal for performing a pairing operation;
the first pairing and tracing module 1012 is configured to transmit the tracing signal and the pairing signal to the second pairing and tracing module 1022 via a cable to be test, and is further configured to perform, for the cable to be test, first wire sequence display control on the first running lights module 1013 according to the pairing signal;
the second pairing and tracing module 1022 is configured to receive the tracing signal and the pairing signal, transmit the tracing signal to the second data processing module 1021, and is further configured to perform, for the cable to be test, second wire sequence display control on the second running lights module 1023 according to the pairing signal;
the second data processing module 1021 is configured to perform, for the cable to be test, audio output control on the audio output module 1024 according to the tracing signal.

It is evident that, by implementing the cable testing device for running lights wire pairing and tracing depicted in FIG. 1, the running lights wire pairing and tracing functions for the cable to be test are jointly implemented through the main test circuit and the secondary test circuit: By implementing, at the first data processing module in the main test circuit, the generation and transmission down of the tracing and pairing control instructions (corresponding to the target signal), the first pairing and tracing module in the main test circuit cooperates with the first running lights module to respond to the target signal, while the second pairing and tracing module in the secondary test circuit cooperates with the second running lights module to respond to the target signal. By arranging the running lights modules, the implementation results of the tracing and pairing functions become more prominent, thereby enhancing the convenience of reviewing the tracing and pairing functions. In addition, the main test circuit is configured to implement pairing and tracing of the wire sequence at the main terminal (near end) of the cable, and the secondary test circuit is configured to implement pairing and tracing at the secondary terminal (remote end), thereby integrating the display function of running lights on the basis of achieving the tracing and pairing functions, expanding the application scenarios of this cable testing device, and facilitating improvements in the applicability and practicality of the cable testing device.

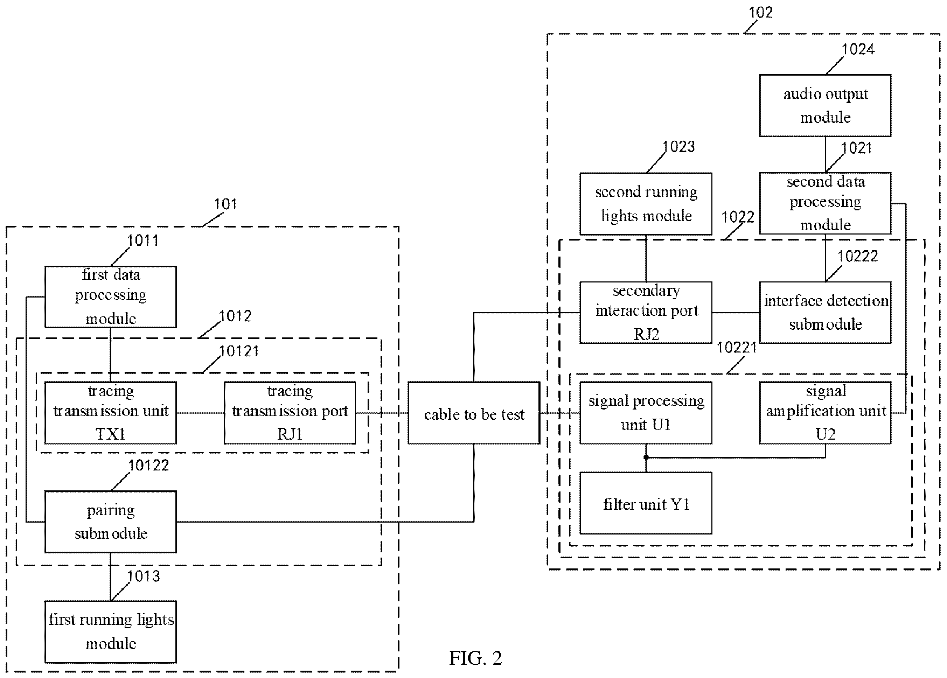

In an optional embodiment, referring to FIG. 2, FIG. 2 is a structural schematic diagram of another cable testing device for running lights wire pairing and tracing according to an embodiment of the present application. As shown in FIG. 2, the first pairing and tracing module 1012 includes a tracing submodule 10121.

A first port of the first data processing module 1011 is electrically connected to a first port of the tracing submodule 10121; a second port of the tracing submodule 10121 is in communication connection with a first port of the second pairing and tracing module 1022;
the tracing submodule 10121 is configured to generate a transmission signal matching with the tracing signal according to the tracing signal transmitted by the first data processing module 1011; and transmit the transmission signal to the second pairing and tracing module 1022 via the cable to be test to trigger the second pairing and tracing module 1022 to perform predetermined signal processing on the transmission signal, the predetermined signal processing comprising filter processing and/or signal amplification processing.

In this optional embodiment, further and optionally, the tracing submodule 10121 includes a tracing transmission unit TX1 and a tracing transmission port RJ1;
a first port of the first data processing module 1011 is electrically connected to a first port of the tracing transmission unit TX1; a second port of the tracing transmission unit TX1 is electrically connected to a first port of the tracing transmission port RJ1;
a second port of the tracing transmission port RJ1 is in communication connection with a first port of the cable to be test; a second port of the cable to be test is in communication connection with a second port of the second pairing and tracing module 1022;
the tracing transmission unit TX1 is configured to perform unit adjustment matching with the tracing signal according to the tracing signal transmitted by the first data processing module 1011, generate a transmission signal matching with the tracing signal, and transmit the transmission signal to the tracing transmission port RJ1 to transmit the transmission signal to the second pairing and tracing module 1022 via the cable to be test through the tracing transmission port RJ1.

In this optional embodiment, the tracing transmission port RJ1, during practical application, serves as a signal transmission port for performing tracing function and may also serve as a signal interaction port for performing pairing function; however, the tracing transmission port RJ1 is configured solely to perform either tracing function or pairing function at any given moment.

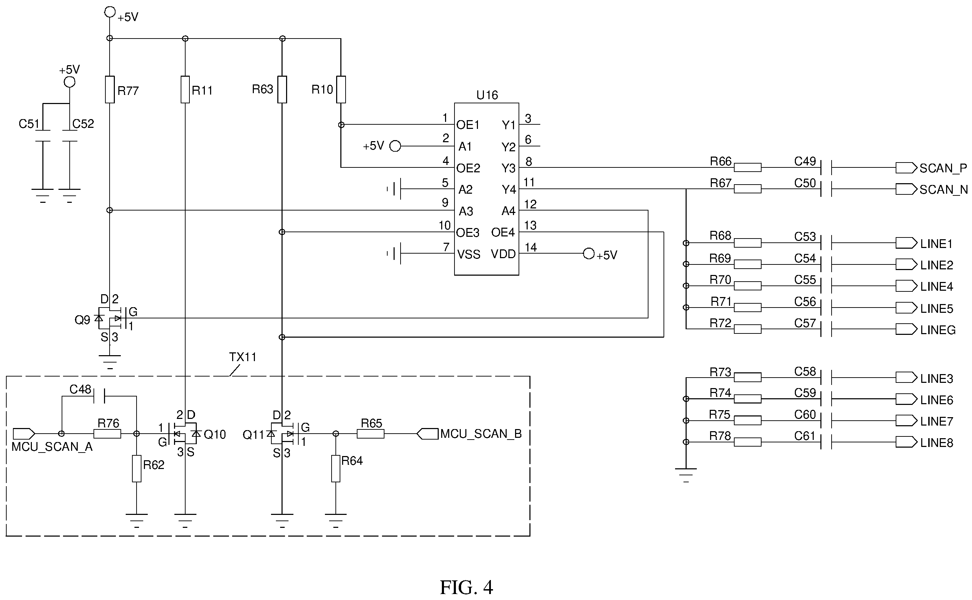

In this optional embodiment, referring to FIG. 4, FIG. 4 is a structural schematic diagram of a tracing transmission unit according to an embodiment of the present application. As shown in FIG. 4, the tracing transmission unit TX1 includes at least a control chip U16 and a signal generation subunit TX11.

The signal generation subunit TX11 is electrically connected to a first port of the first data processing module 1011 via a first interaction port MCU_SCAN_A and a second interaction port MCU_SCAN_B; a second port of the signal generation subunit TX11 is electrically connected to a first port of the control chip U16; a third port of the signal generation subunit TX11 is electrically connected to a second port of the control chip U16.

A third port of the control chip U16 and a fourth port of the control chip U16 are both electrically connected to a first port of the tracing transmission port RJ1;

In this optional embodiment, further, the signal generation subunit TX11 includes a first filter capacitor C48, a first filter resistor R76, a first current-limiting resistor R62, and a first MOS transistor Q10; the signal generation subunit TX11 further includes a second filter resistor R65, a second current-limiting resistor R64, and a second MOS transistor Q11.

A first port of the first data processing module 1011 is electrically connected to a first port of a first interaction port MCU_SCAN_A of the signal generation subunit TX11; a second port of the first interaction port MCU_SCAN_A of the signal generation subunit TX11 is electrically connected to a first port of the first filter capacitor C48 and a first port of the first filter resistor R76 respectively;
a second port of the first filter capacitor C48, a second port of the first filter resistor R76, and a first port of the first current-limiting resistor R62 are all electrically connected to a gate of the MOS transistor Q10; a second port of the first current-limiting resistor R62 is configured to be grounded; a source of the first MOS transistor Q10 is electrically connected to a first port of a first protection resistor R11; a second port of the first protection resistor is configured to connect to a power supply; a drain of the first MOS transistor Q10 is configured to be grounded;
the first port of the first data processing module 1011 is electrically connected to a first port of an MCU_SCAN_B port of the signal generation subunit TX11; a second port of the first interaction port MCU_SCAN_B of the signal generation subunit TX11 is electrically connected to a first port of the second filter resistor R65;
a second port of the second filter resistor R65 is electrically connected to a first port of the second current-limiting resistor R64 and a gate of the second MOS transistor Q11 respectively; a second port of the second current-limiting resistor R64 and a source of the second MOS transistor Q11 are both configured to be grounded; a drain of the second MOS transistor Q11 is electrically connected to a first port of a second protection resistor R63; a second port of the second protection resistor R63 is configured to connect to a power supply.

In this optional embodiment, the first data processing module 1011 controls turning ON and OFF of the first MOS transistor Q10 and the second MOS transistor Q11 through the first interaction port MCU_SCAN_A and the second interaction port MCU_SCAN_B, thereby controlling the control chip U16 to output a required transmission signal.

In this optional embodiment, specifically, the control chip U16 may be a quad buffer with three-state output SN74HC125.

It is evident that, in this optional embodiment, by providing a cable testing device for tracing function at the main terminal (near end), and linking this tracing function with the running lights function, it is beneficial to improve the display accuracy of tracing results and enhance the convenience for users to review tracing results, thereby improving user experience during tracing operations.

In this optional embodiment, optionally, as shown in FIG. 2, the first pairing and tracing module 1012 further includes a pairing submodule.

A second port of the first data processing module 1011 is electrically connected to a first port of the pairing submodule 10122; a second port of the pairing submodule 10122 is electrically connected to a third port of the cable to be test; a third port of the pairing submodule 10122 is electrically connected to a first port of the first running lights module 1013;
the pairing submodule 10122 is configured to receive the pairing signal transmitted by the first data processing module 1011, perform a pairing operation on the main terminal of the cable to be test according to the pairing signal to obtain a main terminal pairing result for the main terminal of the cable to be test, and transmit the main terminal pairing result to the first running lights module 1013 to trigger the first running lights module 1013 to perform a first wire sequence display operation according to the main terminal pairing result.

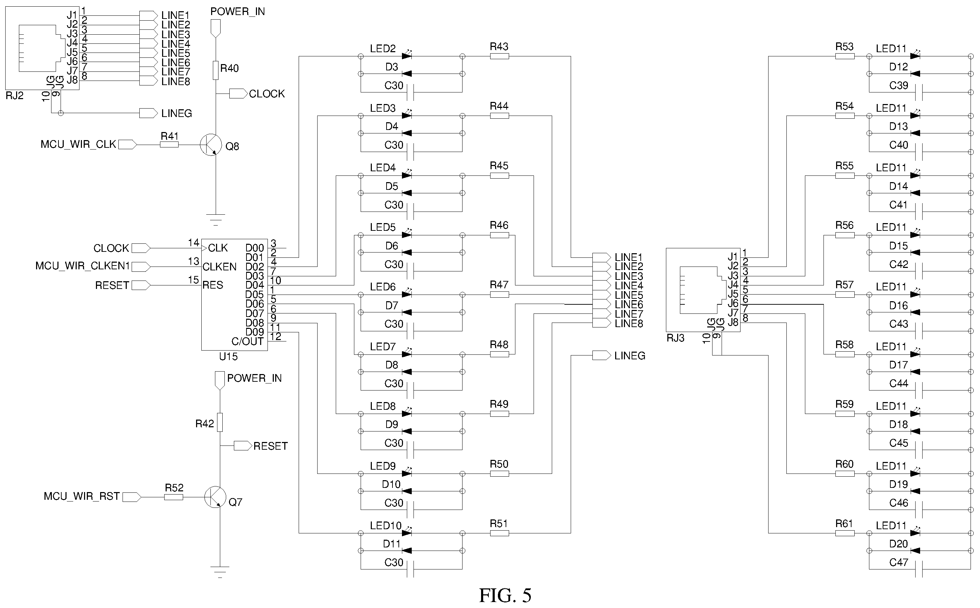

In this optional embodiment, referring to FIG. 5, FIG. 5 is a structural schematic diagram of a pairing submodule according to an embodiment of the present application. As shown in FIG. 5, the pairing submodule 10122 includes a control chip U15, and the control chip U15 may be a decade counter CD4017.

In this optional embodiment, further, the first data processing module 1011 controls the control chip U15 to output alternating high and low level signals via output pins (DO0-D09 and C/OUT in U15 of FIG. 5) using three nets: MC_WIR_CLKEN1, MCU_WIR_RST, and MCU_WIR_CLK. Consequently, when the cable to be test exhibits alternating high and low level changes, a current loop is formed through the main test circuit-cable to be test-secondary test circuit. This current loop may exhibit conditions such as direct connection, open circuit, short circuit, or cross connection.

In this optional embodiment, different current loops correspond to different first wire sequence display operations performed by the first running lights module 1013. Specifically, when an open circuit occurs in the cable to be test, the corresponding wire sequence indicator light will not illuminate. Typical wire sequence results are as follows:
Local wire sequence condition: 1-2-3-4-5-6-7-8-G
Remote wire sequence condition: 1-2-3-4-5-6-7-8-G

When an open circuit occurs on line 2, the line 2 sequence light does not illuminate while other sequence lights illuminate sequentially. When the cable to be test exhibits cross connection, the running lights illuminate crosswise. For example, in a cross connection between line 2 and line 5, the local running lights illuminate normally while the remote line 2 and line 5 sequence lights illuminate crosswise.

It is evident that in this optional embodiment, by providing a cable testing device for pairing function at the main terminal (near end), and linking this pairing function with the running lights function, it is beneficial to improve the display accuracy of pairing results and enhance the convenience for users to review pairing results, thereby improving user experience during pairing operations.

In another optional embodiment, as shown in FIG. 2, the second pairing and tracing module 1022 includes a tracing reception submodule 10221.

A second port of the tracing transmission port RJ1 is in communication connection with a first port of the cable to be test; a second port of the cable to be test is in communication connection with a first port of the tracing reception submodule 10221; a second port of the tracing reception submodule 10221 is electrically connected to a first port of the second data processing module 1021;
the tracing reception submodule 10221 is configured to receive the transmission signal sent by the tracing transmission port RJ1, perform predetermined signal processing corresponding to filter processing and/or signal amplification processing on the transmission signal, and transmit a corresponding predetermined signal processing result to the second data processing module 1021;
the second data processing module 1021 is configured to determine a signal amplitude corresponding to the predetermined signal processing result, generate an audio output signal matching the signal amplitude, and transmit the audio output signal to the audio output module 1024 to output a target audio signal matching the audio output signal through the audio output module 1024; and
the second data processing module 1021 is further configured to generate a display control signal for the second running lights module 1023 according to the predetermined signal processing result, and control the second running lights module 1023 to perform a second wire sequence display operation according to the display control signal, the second wire sequence display operation being configured to indicate a signal intensity corresponding to the transmission signal.

It is evident that, in this optional embodiment, by providing the cable testing device for tracing function at the secondary terminal (remote end) and integrating this tracing function with the running lights function, the application scenarios of the tracing function are expanded beyond the baseline provision of tracing capability at the main terminal. The implementation of tracing functions at both the main and secondary terminals, i.e., near and remote ends, further enhances the functional completeness of the cable testing device for tracing operations, which is conducive to improving the device's applicability. Additionally, the cable testing device integrates interaction with the audio output module, allowing target audio signals corresponding to tracing results to be outputted more conveniently and intuitively. By emitting target audio signals at varying intensities (loudness levels), tracing results at the secondary terminal may be immediately discerned, significantly improving user convenience during tracing operations.

In this optional embodiment, further, the tracing reception submodule 10221 includes a signal processing unit U1, a filter unit Y1, and a signal amplification unit U2.

A second port of the tracing transmission port RJ1 is in communication connection with a first port of the cable to be test; a second port of the cable to be test is in communication connection with a first port of the signal processing unit U1; a second port of the signal processing unit U1 is electrically connected to a first port of the filter unit Y1 and a first port of the signal amplification unit U2 respectively;
a second port of the filter unit Y1 is configured to be grounded; a third port of the filter unit Y1 is configured to connect to a power supply; a second port of the signal amplification unit U2 is configured to be grounded; a third port of the signal amplification unit U2 is electrically connected to a first port of the second data processing module 1021;
the signal processing unit U1 is configured to receive the transmission signal and transmit the transmission signal to the filter unit Y1;
the filter unit Y1 is configured to perform filtering and frequency-selecting operation on the transmission signal and transmit a corresponding filtered frequency-selected signal to the signal amplification unit U2;
the signal amplification unit U2 is configured to perform a signal amplification operation on the filtered frequency-selected signal and feedback a corresponding signal amplification result to the second data processing module 1021; the signal amplification operation includes at least two stages of signal amplification processing.

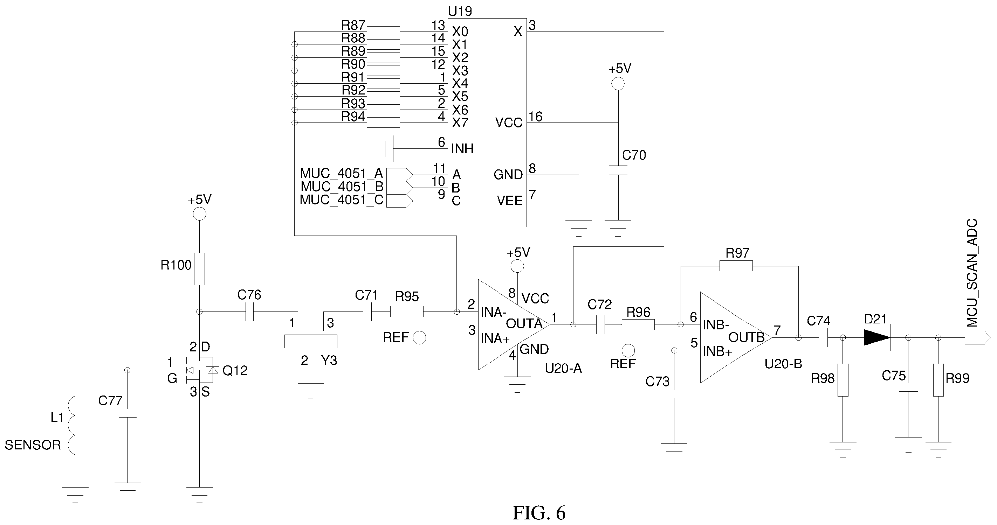

In this optional embodiment, referring to FIG. 6, FIG. 6 is a structural schematic diagram of a tracing reception submodule according to an embodiment of the present application. As shown in FIG. 6, the signal processing unit U1 corresponds to control chip U19 in FIG. 6, the filter unit Y1 corresponds to filter Y3 and third filter capacitor C76 in FIG. 6; the signal amplification unit U2 corresponds to first amplifier U20-A and second amplifier U20-B in FIG. 6. The specific connection methods of internal components within this tracing reception submodule are as depicted in FIG. 6 and are not repeated herein.

In this optional embodiment, the signal (the aforementioned transmission signal) received by receiving antenna L1 in FIG. 6 is frequency-selected by piezoelectric ceramic filter Y3, then amplified by U20 (U20-A and U20-B) through two stages of amplification before being input to the MCU processing module. The first-stage amplification may adjust the gain by controlling the high/low level of pins 9, 10, and 11 of analog switch U19 via the first data processing module 1011, achieving sensitivity adjustment.

It is evident that, in this optional embodiment, the secondary terminal receives the transmission signal sent by the main terminal and implements filtering and signal amplification operations specifically for this signal, thereby improving the signal accuracy to suit subsequent signal processing requirements. This facilitates higher operational accuracy when the secondary terminal receives the tracing signal during communication transmission between main and secondary terminals and executes tracing operations matching the tracing signal. It further enhances the applicability of the cable testing device.

In yet another optional embodiment, as shown in FIG. 2, the second pairing and tracing module 1022 further includes a secondary interaction port RJ2;

A first port of the secondary interaction port RJ2 is configured to be electrically connected to a fourth port of the cable to be test; a second port of the secondary interaction port RJ2 is electrically connected to a first port of the second running lights module 1023;
the pairing submodule 10122 is further configured to transmit the pairing signal to the secondary interaction port RJ2;
the secondary interaction port RJ2 is configured to perform the pairing operation on the secondary terminal of the cable to be test according to the pairing signal to obtain a secondary terminal pairing result for the secondary terminal of the cable to be test, and transmit the secondary terminal pairing result to the second running lights module 1023 to trigger the second running lights module 1023 to perform a second wire sequence display operation according to the secondary terminal pairing result.

In this optional embodiment, for specific operational workflows and resulting wire sequence display outcomes when the second running lights module 1023 performs the second wire sequence display operation according to the pairing result of the secondary terminal, please refer to the detailed explanations provided earlier regarding the operational workflows and display results when the first running lights module 1013 performs the first wire sequence display operation based on the pairing result of the main terminal, which is not repeated herein.

In this optional embodiment, by implementing pairing function at the secondary terminal through the arranged secondary interaction port combined with the arranged second running lights module, the applicability of the cable testing device is improved.

In yet another optional embodiment, as shown in FIG. 2, the second pairing and tracing module 1022 further includes an interface detection submodule 10222.

A third port of the secondary interaction port RJ2 is electrically connected to a first port of the interface detection submodule 10222; a second port of the interface detection submodule 10222 is electrically connected to a second port of the second data processing module 1021;
the interface detection submodule 10222 is configured to collect port operation data corresponding to the secondary interaction port RJ2, determine port connection information of the secondary interaction port RJ2 according to the port operation data, and then transmit the port connection information to the second data processing module 1021; the port connection information comprises first information indicating that the secondary interaction port RJ2 is connected to the tracing transmission port RJ1 via a cable or non-first information;
the interface detection submodule 10222 is further configured to receive a port control instruction fed back by the second data processing module 1021 for the port connection information, and perform port control on the secondary interaction port RJ2 according to the port control instruction, the port control including port start and stop control.

In this optional embodiment, as mentioned above, when the tracing transmission port RJ1 and the secondary interaction port RJ2 are connected via a cable, the interface detection submodule 10222 may automatically detect the action and state of the two ports being connected. At this point, it controls the main test circuit and secondary test circuit to execute functional operations related to the pairing function.

It is evident that in this optional embodiment, by arranging an intelligent detection module specifically for the secondary interaction port, i.e., the interface detection submodule, the secondary test circuit may flexibly adjust between executing tracing function or pairing function in real time based on the connection status of the secondary interaction port. This enhances the switching accuracy and execution precision of both tracing and pairing functions at the secondary terminal.

In yet another optional embodiment, as shown in FIG. 2, the main test circuit 101 further includes a cable-length measurement module 1014.

A first port of the cable-length measurement module 1014 is configured to be electrically connected to a first port of a cable group to be test; a second port of the cable-length measurement module 1014 is electrically connected to a third port of the first data processing module 1011;
the first data processing module 1011 is further configured to transmit a generated cable-length measurement trigger signal to the cable-length measurement module 1014 while transmitting a preset pulse wave to the cable group to be test;
the cable-length measurement module 1014 is configured to perform a measurement operation for the preset pulse wave on the cable group to be test and write a corresponding measurement result into a result register of the cable-length measurement module 1014;
the first data processing module 1011 is further configured to read the measurement result, perform calculation based on a preset algorithm on the measurement result, and display a corresponding calculation result on a display module externally connected to the first data processing module 1011.

In this optional embodiment, the cable-length measurement module 1014 specifically refers to a TDC cable-length measurement module. Specifically, it employs the MS1003 as the main measurement unit for time-to-digital conversion (TDC), coupled with network port isolation transformers, multiple single-pole double-throw analog switches, a high-speed comparator, and other components to form a cable-length measurement management module, which communicates with the MCU processing module via high-speed SPI (Serial Peripheral Interface).

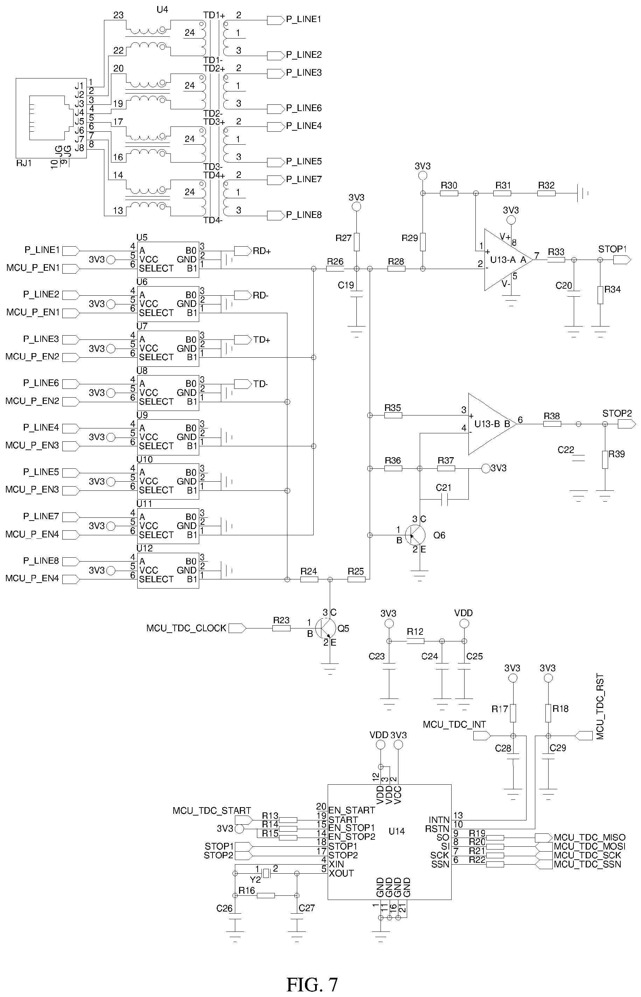

In this optional embodiment, referring to FIG. 7, FIG. 7 is a structural schematic diagram of a cable-length measurement module according to an embodiment of the present application. As shown in FIG. 7, a trigger signal is sent to the cable-length measurement module 1014 via the MCU_TDC_START net in the first data processing module 1011, while a pulse wave is sent to the cable group to be test via the MCU_TDC_CLOCK net. At this point, the TDC gate circuit in the cable-length measurement module 1014 starts counting. It records the count result upon the generation of a stop (stop1/stop2) signal in the cable-length measurement module 1014, and stops counting upon reaching the expected pulse count for STOP. After time measurement concludes, the cable-length measurement module 1014 automatically writes the measurement results of each pulse in sequence to corresponding result registers. The first data processing module 1011 reads the measurement results from the registers in the cable-length measurement module 1014 via SPI communication, performs algorithmic calculations, and displays the calculation results on a display module configured for the cable testing device. The display module may be externally connected to the cable testing device or internally integrated thereon, which is not limited in this optional embodiment.

It is evident that, in this optional embodiment, the cable testing device integrates cable-length measurement functionality beyond the baseline integration of running lights display, tracing function, and pairing function. This enriches the functional categories of the cable testing device, thereby enhancing the applicability and practicality of the cable testing device.

The operational principle of the cable testing device for running lights wire pairing and tracing in embodiments of the present application is as follows:

In embodiments of the present application, based on current usage requirements, a user triggers different operational functions on the cable testing device, including tracing function, pairing function, and cable-length measurement function. Subsequently, an initial control instruction (i.e., the aforementioned target signal) matching the operational function is generated at the first data processing module of the main test circuit. At the main terminal (main test circuit), through the first pairing and tracing module combined with the first running lights module and audio output module, tracing operation, pairing operation, or cable-length measurement operation matching the control instruction is executed. Simultaneously, when the control instruction is executed at the main terminal, the main terminal synchronizes the control instruction to the second pairing and tracing module, enabling the second pairing and tracing module at the secondary terminal, combined with the second running lights module and audio output module, to implement tracing or pairing operations matching the control instruction, thereby achieving pairing and tracing functionality at both near and remote ends (main and secondary terminals).

It should be noted that the above operational description pertains to a single cable testing device for running lights wire pairing and tracing. For principles related to multiple such devices, please refer to the detailed explanation regarding the operational principle of a single device above, which are not repeated herein.

### Embodiment 2

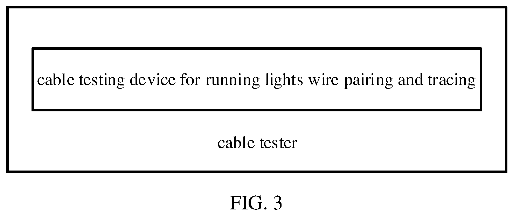

Referring to FIG. 3, FIG. 3 is a structural schematic diagram of a cable tester according to an embodiment of the present application. The cable tester includes the cable testing device for running lights wire pairing and tracing according to any one of the implementations in Embodiment 1. Moreover, the cable tester includes, but is not limited to, instruments with cable testing functions such as a cable tracer and a cable pairing device. It should be noted that, for detailed descriptions of the cable testing device for running lights wire pairing and tracing, please refer to relevant content in Embodiment 1, which are not repeated in this embodiment.

It is evident that, by implementing the cable tester depicted in FIG. 3, the running lights wire pairing and tracing functions for the cable to be test are jointly implemented through the main test circuit and the secondary test circuit: By implementing, at the first data processing module in the main test circuit, the generation and transmission down of the tracing and pairing control instructions (corresponding to the target signal), the first pairing and tracing module in the main test circuit cooperates with the first running lights module to respond to the target signal, while the second pairing and tracing module in the secondary test circuit cooperates with the second running lights module to respond to the target signal. By arranging the running lights modules, the implementation results of the tracing and pairing functions become more prominent, thereby enhancing the convenience of reviewing the tracing and pairing functions. In addition, the main test circuit is configured to implement pairing and tracing of the wire sequence at the main terminal (near end) of the cable, and the secondary test circuit is configured to implement pairing and tracing at the secondary terminal (remote end), thereby integrating the display function of running lights on the basis of achieving the tracing and pairing functions, expanding the application scenarios of this cable testing device, and facilitating improvements in the applicability and practicality of the cable testing device.

The above brings a detailed description of the cable testing device for running lights wire pairing and tracing and the cable tester disclosed in the embodiments of the present application. The specific embodiments have been applied in this article to illustrate the principle and implementation of the present application, but the above preferred embodiments are not intended to limit the present application, and the above embodiments are only used to facilitate the understanding of the method and its core concept of the present application. Meanwhile, for those skilled in the art, there may be changes in the specific implementation and the scope of application based on the concept of the present application without departing from the spirit and scope of the present application, so the scope of protection of the present application is determined by the scope defined in the claims.

## Claims

1. A cable testing device for running lights wire pairing and tracing, wherein the cable testing device comprises a main test circuit (101) and a secondary test circuit (102) , the main test circuit (101) comprising a first pairing and tracing module (1012), a first data processing module (1011) connected to the first pairing and tracing module (1012), and a first running lights module (1013); the secondary test circuit (102) comprising an audio output module (1024), a second pairing and tracing module (1022), a second data processing module (1021) connected to the second pairing and tracing module (1022), and a second running lights module (1023), the audio output module (1024) being connected to the second data processing module (1021), wherein:
the first data processing module (1011) is configured to generate a tracing signal for performing a tracing operation and a pairing signal for performing a pairing operation;
the first pairing and tracing module (1012) is configured to transmit the tracing signal and the pairing signal to the second pairing and tracing module (1022) via a cable to be test, and is further configured to perform, for the cable to be test, first wire sequence display control on the first running lights module (1013) according to the pairing signal;
the second pairing and tracing module (1022) is configured to receive the tracing signal and the pairing signal, transmit the tracing signal to the second data processing module (1021), and is further configured to perform, for the cable to be test, second wire sequence display control on the second running lights module (1023) according to the pairing signal;
the second data processing module (1021) is configured to perform, for the cable to be test, audio output control on the audio output module (1024) according to the tracing signal.

2. The cable testing device for running lights wire pairing and tracing according to claim 1, wherein the first pairing and tracing module (1012) comprises a tracing submodule (10121);
a first port of the first data processing module (1011) is electrically connected to a first port of the tracing submodule (10121); a second port of the tracing submodule (10121) is in communication connection with a first port of the second pairing and tracing module (1022);
the tracing submodule (10121) is configured to generate a transmission signal matching with the tracing signal according to the tracing signal transmitted by the first data processing module (1011); and transmit the transmission signal to the second pairing and tracing module (1022) via the cable to be test to trigger the second pairing and tracing module (1022) to perform predetermined signal processing on the transmission signal, the predetermined signal processing comprising filter processing and/or signal amplification processing.

3. The cable testing device for running lights wire pairing and tracing according to claim 2, wherein the tracing submodule (10121) comprises a tracing transmission unit (TX1) and a tracing transmission port (RJ1);
a first port of the first data processing module (1011) is electrically connected to a first port of the tracing transmission unit (TX1); a second port of the tracing transmission unit (TX1) is electrically connected to a first port of the tracing transmission port (RJ1);
a second port of the tracing transmission port (RJ1) is in communication connection with a first port of the cable to be test; a second port of the cable to be test is in communication connection with a second port of the second pairing and tracing module (1022);
the tracing transmission unit (TX1) is configured to perform unit adjustment matching with the tracing signal according to the tracing signal transmitted by the first data processing module (1011), generate a transmission signal matching with the tracing signal, and transmit the transmission signal to the tracing transmission port (RJ1) to transmit the transmission signal to the second pairing and tracing module (1022) via the cable to be test through the tracing transmission port (RJ1).

4. The cable testing device for running lights wire pairing and tracing according to claim 3, wherein the first pairing and tracing module (1012) further comprises a pairing submodule (10122);
a second port of the first data processing module (1011) is electrically connected to a first port of the pairing submodule (10122); a second port of the pairing submodule (10122) is electrically connected to a third port of the cable to be test; a third port of the pairing submodule (10122) is electrically connected to a first port of the first running lights module (1013);
the pairing submodule (10122) is configured to receive the pairing signal transmitted by the first data processing module (1011), perform a pairing operation on a main terminal of the cable to be test according to the pairing signal to obtain a main terminal pairing result for the main terminal of the cable to be test, and transmit the main terminal pairing result to the first running lights module (1013) to trigger the first running lights module (1013) to perform a first wire sequence display operation according to the main terminal pairing result.

5. The cable testing device for running lights wire pairing and tracing according to claim 4, wherein the second pairing and tracing module (1022) comprises a tracing reception submodule (10221);
a second port of the tracing transmission port (RJ1) is in communication connection with a first port of the cable to be test; a second port of the cable to be test is in communication connection with a first port of the tracing reception submodule (10221); a second port of the tracing reception submodule (10221) is electrically connected to a first port of the second data processing module (1021);
the tracing reception submodule (10221) is configured to receive the transmission signal sent by the tracing transmission port (RJ1), perform predetermined signal processing corresponding to filter processing and/or signal amplification processing on the transmission signal, and transmit a corresponding predetermined signal processing result to the second data processing module (1021);
the second data processing module (1021) is configured to determine a signal amplitude corresponding to the predetermined signal processing result, generate an audio output signal matching the signal amplitude, and transmit the audio output signal to the audio output module (1024) to output a target audio signal matching the audio output signal through the audio output module (1024);
the second data processing module (1021) is further configured to generate a display control signal for the second running lights module (1023) according to the predetermined signal processing result, and control the second running lights module (1023) to perform a second wire sequence display operation according to the display control signal, the second wire sequence display operation being configured to indicate a signal intensity corresponding to the transmission signal.

6. The cable testing device for running lights wire pairing and tracing according to claim 5, wherein the tracing reception submodule (10221) comprises a signal processing unit (U1), a filter unit (Y1), and a signal amplification unit (U2);
a second port of the tracing transmission port (RJ1) is in communication connection with a first port of the cable to be test; a second port of the cable to be test is in communication connection with a first port of the signal processing unit (U1); a second port of the signal processing unit (U1) is electrically connected to a first port of the filter unit (Y1) and a first port of the signal amplification unit (U2) respectively;
a second port of the filter unit (Y1) is configured to be grounded; a third port of the filter unit (Y1) is configured to connect to a power supply; a second port of the signal amplification unit (U2) is configured to be grounded; a third port of the signal amplification unit (U2) is electrically connected to a first port of the second data processing module (1021);
the signal processing unit (U1) is configured to receive the transmission signal and transmit the transmission signal to the filter unit (Y1);
the filter unit (Y1) is configured to perform filtering and frequency-selecting operation on the transmission signal and transmit a corresponding filtered frequency-selected signal to the signal amplification unit (U2);
the signal amplification unit (U2) is configured to perform a signal amplification operation on the filtered frequency-selected signal and feedback a corresponding signal amplification result to the second data processing module (1021); the signal amplification operation comprises at least two stages of signal amplification processing.

7. The cable testing device for running lights wire pairing and tracing according to claim 5 or 6, wherein the second pairing and tracing module (1022) further comprises a secondary interaction port (RJ2);
a first port of the secondary interaction port (RJ2) is configured to be electrically connected to a fourth port of the cable to be test; a second port of the secondary interaction port (RJ2) is electrically connected to a first port of the second running lights module (1023);
the pairing submodule (10122) is further configured to transmit the pairing signal to the secondary interaction port (RJ2);
the secondary interaction port (RJ2) is configured to perform the pairing operation on a secondary terminal of the cable to be test according to the pairing signal to obtain a secondary terminal pairing result for the secondary terminal of the cable to be test, and transmit the secondary terminal pairing result to the second running lights module (1023) to trigger the second running lights module (1023) to perform a second wire sequence display operation according to the secondary terminal pairing result.

8. The cable testing device for running lights wire pairing and tracing according to claim 7, wherein the second pairing and tracing module (1022) further comprises an interface detection submodule (10222);
a third port of the secondary interaction port (RJ2) is electrically connected to a first port of the interface detection submodule (10222); a second port of the interface detection submodule (10222) is electrically connected to a second port of the second data processing module (1021);
the interface detection submodule (10222) is configured to collect port operation data corresponding to the secondary interaction port (RJ2), determine port connection information of the secondary interaction port (RJ2) according to the port operation data, and then transmit the port connection information to the second data processing module (1021); the port connection information comprises first information indicating that the secondary interaction port (RJ2) is connected to the tracing transmission port (RJ1) via a cable or non-first information;
the interface detection submodule (10222) is further configured to receive a port control instruction fed back by the second data processing module (1021) for the port connection information, and perform port control on the secondary interaction port (RJ2) according to the port control instruction, the port control comprising port start and stop control.

9. The cable testing device for running lights wire pairing and tracing according to any one of claims 1 to 6 and 8, wherein the main test circuit (101) further comprises a cable-length measurement module (1014);
a first port of the cable-length measurement module (1014) is configured to be electrically connected to a first port of a cable group to be test; a second port of the cable-length measurement module (1014) is electrically connected to a third port of the first data processing module (1011);
the first data processing module (1011) is further configured to transmit a generated cable-length measurement trigger signal to the cable-length measurement module (1014) while transmitting a preset pulse wave to the cable group to be test;
the cable-length measurement module (1014) is configured to perform a measurement operation for the preset pulse wave on the cable group to be test and write a corresponding measurement result into a result register of the cable-length measurement module (1014);
the first data processing module (1011) is further configured to read the measurement result, perform calculation based on a preset algorithm on the measurement result, and display a corresponding calculation result on a display module externally connected to the first data processing module (1011).

10. A cable tester, wherein the cable tester comprises a device body, and the cable tester comprises the cable testing device for running lights wire pairing and tracing according to any one of claims 1 to 9.
